(19) Europäisches Patentamt
European Patent Office
Office européen des brevets

(11) **EP 4 127 759 B1**

(12) **FASCICULE DE BREVET EUROPEEN**

(45) Date de publication et mention
de la délivrance du brevet:
**14.02.2024 Bulletin 2024/07**

(21) Numéro de dépôt: **21712844.6**

(22) Date de dépôt: **22.03.2021**

(51) Classification Internationale des Brevets (IPC):
**G01R 33/60** (2006.01)     **G01N 24/10** (2006.01)
**G01R 33/46** (2006.01)

(52) Classification Coopérative des Brevets (CPC):
**G01R 33/60; G01N 24/10;** G01R 33/4608

(86) Numéro de dépôt international:
**PCT/EP2021/057204**

(87) Numéro de publication internationale:
**WO 2021/191119 (30.09.2021 Gazette 2021/39)**

(54) **PROCEDE DE DETECTION DE SPINS PAR COMPTAGE DE PHOTONS**

VERFAHREN ZUR SPIN-ERKENNUNG DURCH PHOTONENZÄHLUNG

METHOD FOR DETECTING SPINS BY PHOTON COUNTING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.03.2020 FR 2002976**

(43) Date de publication de la demande:
**08.02.2023 Bulletin 2023/06**

(73) Titulaire: **Commissariat à l'Energie Atomique et aux Energies
Alternatives
75015 Paris (FR)**

(72) Inventeurs:
• **BERTET, Patrice**
**91191 GIF SUR YVETTE Cedex (FR)**
• **FLURIN, Emmanuel**
**91191 GIF SUR YVETTE Cedex (FR)**

(74) Mandataire: **Atout PI Laplace
Immeuble "Visium"
22, avenue Aristide Briand
94117 Arcueil Cedex (FR)**

(56) Documents cités:
• Y. KUBO ET AL: "Electron spin resonance detected by a superconducting qubit", PHYS. REV. B, vol. 86, no. 6, 10 août 2012 (2012-08-10), pages 064514-1-064514-6, XP055233541, US ISSN: 1098-0121, DOI: 10.1103/PhysRevB.86.064514
• RANJAN V ET AL: "Pulsed electron spin resonance spectroscopy in the Purcell regime", JOURNAL OF MAGNETIC RESONANCE, ACADEMIC PRESS, ORLANDO, FL, US, vol. 310, 4 décembre 2019 (2019-12-04), XP085970896, ISSN: 1090-7807, DOI: 10.1016/J.JMR.2019.106662 [extrait le 2019-12-04]
• MCCOY M A ET AL: "Nuclear spin noise at room temperature", CHEMICAL PHYSICS LETTERS, ELSEVIER BV, NL, vol. 159, no. 5-6, 21 juillet 1989 (1989-07-21), pages 587-593, XP002489847, ISSN: 0009-2614, DOI: 10.1016/0009-2614(89)87537-2 cité dans la demande
• A. BIENFAIT ET AL: "Reaching the quantum limit of sensitivity in electron spin resonance", NATURE NANOTECHNOLOGY, vol. 11, no. 3, 14 décembre 2015 (2015-12-14), pages 253-257, XP055492571, London ISSN: 1748-3387, DOI: 10.1038/nnano.2015.282 cité dans la demande

    **(Cont. page suivante)**

EP 4 127 759 B1

- PROBST S ET AL: "Inductive-detection electron-spin resonance spectroscopy with 65 spins/qrttextHz sensitivity", ARXIV.ORG, CORNELL UNIVERSITY LIBRARY, 201 OLIN LIBRARY CORNELL UNIVERSITY ITHACA, NY 14853, 30 août 2017 (2017-08-30), XP081291421, DOI: 10.1063/1.5002540 cité dans la demande

**Description**

L'invention porte sur un procédé de détection de spins par comptage de photons. Elle s'applique principalement, mais pas exclusivement, à la spectroscopie de Résonance Paramagnétique Electronique (RPE).

La spectroscopie de Résonance Paramagnétique Electronique exploite la propriété des électrons non appariés, présents dans certaines espèces chimiques (radicaux libres et sels et complexes de métaux de transition) d'absorber et réémettre l'énergie d'un rayonnement électromagnétique, typiquement hyperfréquence, lorsqu'ils sont placés dans un champ magnétique.

Le spectre d'absorption ou d'émission du rayonnement électromagnétique renseigne sur l'environnement chimique de l'électron non apparié ou du noyau, respectivement.

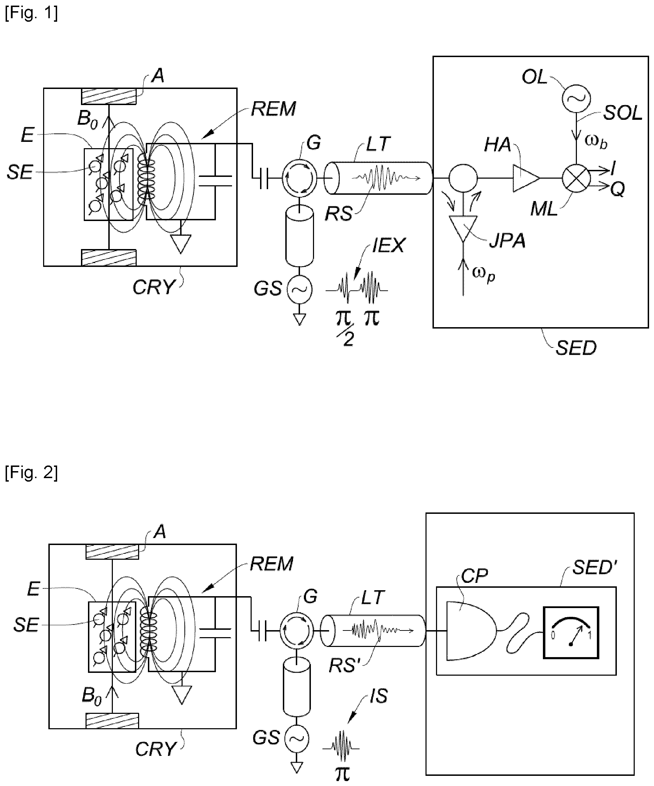

[Fig. 1] illustre schématiquement un appareil de spectroscopie de Résonance Paramagnétique Electronique selon l'art antérieur, voir par exemple (Bienfait 2016), (Probst 2017) et (Ranjan 2020).

Un échantillon E, contenant un ensemble de N spins électroniques SE, est placé dans une enceinte cryogénique CRY, dans le champ magnétique $B_0$ généré par un aimant ou une bobine supraconductrice A. L'intensité du champ magnétique détermine la pulsation de résonance $\omega_0$ des spins électroniques :

$$\omega_0 = -\gamma B_0$$

Où $\gamma$ est le rapport gyromagnétique de l'électron. La fréquence $f_L = \omega_0/2\pi$ est dite fréquence de Larmor. Typiquement, elle se situe dans la région spectrale des hyperfréquences car le rapport gyromagnétique d'un électron libre vaut environ 28 GHz/T.

L'échantillon E, en outre, est couplé magnétiquement à un résonateur électromagnétique REM accordé la fréquence de Larmor et modélisé par un circuit LC parallèle. Dans le cas de (Bienfait 2016), (Probst 2017) et (Ranjan 2020), le résonateur est une structure planaire comprenant deux électrodes interdigités, formant un condensateur, reliés en leur centre par une ligne conductrice inductive, à proximité de laquelle se trouve la région sensible. Le plan du résonateur est parallèle au champ magnétique $B_0$. D'autres types de résonateurs peuvent être utilisés, par exemple des cavités conductrices entourant l'échantillon de tous les côtés.

On désigne par « g » la constante de couplage de l'échantillon au résonateur, et par Q son facteur de qualité. Typiquement, la constante de couplage est suffisamment élevée pour que l'effet Purcell domine la dynamique de relaxation des spins : $\Gamma_1 \approx \Gamma_P$ où $\Gamma_1$ est le taux de relaxation en énergie des spins et $\Gamma_P$ le facteur de Purcell donné par

$$\Gamma_P = 4g^2/\kappa$$

où $\kappa = \omega_0/Q$ est le taux de dissipation de l'énergie dans le résonateur.

Un générateur de signaux GS applique au résonateur REM une séquence d'impulsions hyperfréquence IEX à la fréquence de Larmor. Ces impulsions, dites d'excitation excitent les spins de l'échantillon couplé au résonateur.

La séquence d'impulsions d'excitation la plus utilisée est celle dite à « écho de spin ». Elle comprend une première impulsion dite « $\pi/2$ », qui induit un basculement des spins - initialement alignés avec le champ magnétique $B_0$ - dans un plan perpendiculaire à ce dernier. Les spins effectuent un mouvement de précession autour du champ magnétique $B_0$ et, ce faisant, émettent un premier signal électromagnétique à la fréquence de Larmor. Ce signal est dit de « décroissance libre » (FID, de l'anglais « Free Induction Decay ») car son intensité décroît exponentiellement à cause de la décohérence des spins, avec un temps caractéristique $T_2^* = (\Gamma_2^*)^{-1}$. Le taux de décohérence $\Gamma_2^*$ dépend des propriétés de l'échantillon et de l'homogénéité du champ magnétique $B_0$. Après un certain temps - inférieur au temps de perte de cohérence des spins $T_2 = (\Gamma_2)^{-1}$ - une impulsion dite « $\pi$ » est appliquée. Cette deuxième impulsion inverse l'orientation des spins et provoque l'émission d'un deuxième signal électromagnétique dit d'écho.

Les signaux électromagnétiques émis par les spins sont convertis en signal électronique de réponse RS par le résonateur. Un gyrateur G permet de séparer les impulsions d'excitation du signal de réponse RS. En particulier, c'est le signal d'écho qui est pris en compte pour détecter les spins.

Le signal de réponse RS parvient, via une ligne de transmission adaptée LT (typiquement un câble coaxial) à un système électronique de détection SED.

Par exemple, dans le cas de (Bienfait 2016), (Probst 2017) et (Ranjan 2020), le système électronique de détection comprend un amplificateur paramétrique à jonction de Josephson JPA pompé à une pulsation $\omega_p \approx 2\omega_0$ ; le signal amplifié est ultérieurement amplifié par un amplificateur à HEMT HA, puis mélangé dans un mélangeur ML avec un signal SOL d'oscillateur local OL à la pulsation $\omega_0$ et les composantes in phase I et en quadrature Q du signal en bande de base issu du mélange sont détectées (détection homodyne).

Il est possible de démontrer - voir par exemple (Bienfait 2016) - que, dans le cas où le facteur de qualité du résonateur est limité par le couplage avec l'antenne de détection (régime de suramortissement) - l'amplitude d'un signal d'écho de spin vaut

$$X_e = pN\sqrt{\Gamma_P/2\Gamma_2^*}$$

Où « p » est la polarisation à l'équilibre de l'ensemble de spin, qui dépend de la température selon la statistique de Maxwell-Boltzmann et N le nombre de spins de l'échantillon.

Le niveau de bruit est donné par

$$\delta X = \sqrt{n}/2$$

avec $n = n_{eq} + n_{amp}$ où $n_{eq}$ est le bruit thermique du champ hyperfréquence, $n_{eq} = 1 + 2\langle n \rangle$ avec $\langle n \rangle = 1/(e^{\hbar\omega 0/kBT} - 1)$ exprimant le nombre moyen de photons par mode à la température T ($k_B$ : constante de Boltzmann) et $n_{amp}$ est le bruit rajouté par l'amplificateur. Le rapport signal-sur-bruit de la détection par écho homodyne vaut donc

$$SN_{e,h} = 2pN\sqrt{\Gamma_P/2n\Gamma_2^*}.$$

où les indices « e » et « h » signifient « écho de spin » est « détection homodyne », respectivement.

Même dans le cas idéal ou p=1 (polarisation complète de l'échantillon) et n=1 (détecteur à la limite quantique du bruit et température très faible), pour obtenir un rapport signal sur bruit égal à 1 il faut donc que le nombre de spins dans l'échantillon satisfasse $N \geq \sqrt{2\Gamma_2^*/\Gamma_P}$.

Or, en général $\Gamma_2^*/\Gamma_P \gg 1$, par conséquent N»1.

Les auteurs de (Probst 2017) ont obtenu, au moyen d'un appareil du type de la [Fig. 1], une sensibilité de détection de 65 $\text{spins}/\sqrt{\text{Hz}}$ et une cadence d'acquisition (limitée par $\Gamma_P$) de 10 Hz, ce qui leur a permis de détecter le signal généré par un échantillon contenant seulement 200 spins. Pour ce faire, ils ont travaillé à une température de 10 mK, de telle sorte que p≈1 et $n_{eq}$ ≈1, maximisé le facteur de qualité du résonateur électromagnétique et sa constante de couplage à l'échantillon et utilisé un amplificateur à la limite quantique du bruit, tel que $n_{amp} \approx 0$.

D'autres techniques de détection de spin ont été utilisées dans l'art antérieur, mais elles n'ont pas permis d'atteindre des sensibilités aussi élevées.

En particulier, d'autres séquences d'excitation peuvent être utilisées. Par exemple, il est possible de n'utiliser qu'une impulsion « π/2 » et détecter directement le signal FID, sans induire un écho.

Dans (Kubo 2012), un signal FID a été détecté non pas par des techniques électroniques classiques, telle qu'une détection homodyne ou hétérodyne, mais par comptage de photons hyperfréquence au moyen d'un qubit (c'est-à-dire d'un système quantique à deux niveaux) supraconducteur, du type à transmon. Dans cette méthode, aussi bien l'échantillon que le qubit de détection sont agencés dans une cavité hyperfréquence dont la fréquence de résonance doit être modifiée de manière dynamique pour permettre d'abord l'excitation des spins électroniques par une impulsion « π/2 », puis la détection du signal FID par le qubit. Cette technique est complexe à mettre en oeuvre et n'a permis d'atteindre qu'une sensibilité de l'ordre de $10^5$ $\text{spins}/\sqrt{\text{Hz}}$, plusieurs ordres de magnitude moins bonne que le résultat - postérieur - de (Probst 2017).

L'utilisation d'une impulsion « π » seule induit l'émission d'un signal incohérent (« bruit ») provoqué par le retour à l'équilibre de spins. Un tel signal a été observé - en Résonance Magnétique Nucléaire - par (McCoy 1989), mais considéré sans intérêt pratique en raison de sa très faible sensibilité.

L'invention vise à améliorer la sensibilité de la détection de spins, et notamment à rendre possible des mesures sur des échantillons contenant un très faible nombre de spins, par exemple 10 ou moins, voire un seul.

Conformément à l'invention, ce but est atteint grâce à la détection, au moyen d'un compteur de photons à radiofréquence ou hyperfréquence, du signal incohérent émis par les spins excités par une impulsion d'inversion des spins (impulsion « π »). Un objet de l'invention est donc un procédé de détection de spin comprenant les étapes suivantes :

a) placer un échantillon contenant des spins dans un champ magnétique stationnaire ;
b) coupler magnétiquement l'échantillon à un résonateur électromagnétique présentant une fréquence de résonance $\omega_0/2\pi$ égale à la fréquence de Larmor des spins dans le champ magnétique stationnaire, la constante de couplage et le facteur de qualité du résonateur étant suffisamment élevés pour que le couplage avec le résonateur domine la dynamique de relaxation des spins ;

c) exciter les spins de l'échantillon au moyen d'une impulsion électromagnétique radio- ou hyperfréquence à ladite fréquence de Larmor ; et

d) détecter un signal électromagnétique émis par les spins de l'échantillon dans un mode du résonateur électromagnétique en réponse à la dite impulsion au moyen d'un dispositif de comptage de photons à radiofréquence ou hyperfréquence ; caractérisé en ce que l'impulsion électromagnétique radio- ou hyperfréquence à la fréquence de Larmor est une impulsion de basculement de spin, moyennant quoi le signal détecté est un signal de bruit produit par le retour à l'équilibre des spins.

On entend par « radiofréquence » des fréquences comprises entre 1 MHz et 1 GHz et « hyperfréquence » entre 1 GHz et 100 GHz.

Les dessins annexés illustrent l'invention :

[Fig. 1], déjà décrite, illustre schématiquement un appareil de spectroscopie de Résonance Paramagnétique Electronique selon l'art antérieur ;

[Fig. 2] illustre schématiquement un appareil de spectroscopie de Résonance Paramagnétique Electronique pour la mise en oeuvre d'un procédé selon l'invention ;

[Fig. 3] illustre la structure d'un compteur de photons hyperfréquences pouvant être utilisé dans l'appareil de la [Fig. 2] ;

[Fig. 4a] et

[Fig. 4b] illustrent des résultats expérimentaux.

Le procédé de l'invention peut être mis en oeuvre au moyen d'un appareil du type illustré sur la [Fig. 2] qui se différencie de celui de la [Fig. 1] essentiellement par le fait que son système électronique de détection SED' du signal hyperfréquence émis par les spins de l'échantillon E est basé sur un dispositif CP de comptage de photons à hyperfréquence.

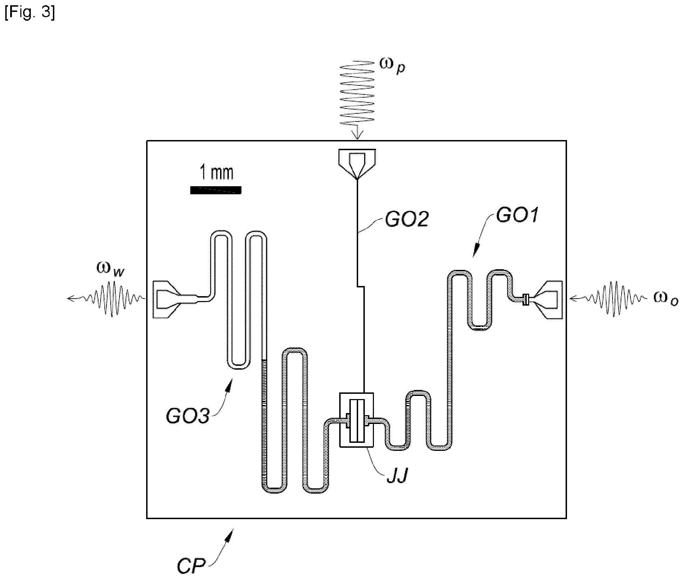

Le dispositif de comptage de photons CP peut être un qubit supraconducteur, notamment du type à transmon, tel que décrit dans (Lescanne 2019) et illustré dans la [Fig. 3]. Ce dispositif comprend une jonction Josephson JJ en configuration transmon reliée à trois tronçons de guide d'onde planaire. Le premier tronçon de guide d'onde GO1 forme un résonateur à demi-longueur d'onde $(\lambda/2)$ résonant à la pulsation $\omega_0$ des photons à détecter. Le deuxième tronçon de guide d'onde GO2 est destiné à diriger vers la jonction Josephson un signal dit de pompe, à une pulsation $\omega_p$. Le troisième tronçon de guide d'onde GO3 forme une paire de résonateurs à demi-longueur d'onde $(\lambda/2)$, résonant à une pulsation $\omega_w$ dite « de déchet », couplé via un filtre passe-bande dit « de Purcell » à un environnement froid (à l'échelle des milliKelvin) présentant une impédance caractéristique de 50 Ohm. La jonction Josephson en configuration transmon se comporte comme un système à deux niveaux. Lorsqu'elle se trouve dans son niveau fondamental, l'arrivée simultanée d'un photon à la pulsation $\omega_0$ et d'un photon de pompe à la pulsation $\omega_P$ provoque la transition de la jonction Josephson vers son niveau excité, l'énergie restante étant dissipée dans l'environnement froid sous la forme d'un photon à la pulsation $\omega_w$. La lecture de l'état du transmon se fait en sondant l'un des deux résonateurs auquel est couplé le qubit (par exemple le mode de déchet) avec une impulsion hyperfréquence à sa fréquence de résonance ; à cause du couplage dispersif au qubit, la phase de l'impulsion réfléchie par le résonateur permet de déduire l'état du qubit et donc la présence d'un photon. Le dispositif est réinitialisé en injectant un photon de pulsation $\omega_w$ dans GO3, ce dernier se combinant avec un photon de pompe dans la jonction Josephson pour ramener cette dernière dans son état fondamental, l'excès d'énergie étant évacué par un photon à la longueur d'onde $\omega_0$.

D'autres types de dispositifs permettent le comptage de photons hyperfréquence, voire radiofréquence. Par exemple, (Walsh 2017) propose un détecteur de type bolomètre, utilisant une jonction Josephson pour détecter l'échauffement d'un feuillet de graphène induit par un photon unique.

En outre, le système électronique de génération de signaux GS de l'appareil de la [Fig. 2] est configuré pour générer, au lieu de séquences d'écho de spin, des simples impulsions d'inversion IS, ou « $\pi$ ».

Plus généralement, les impulsions d'inversion, induisant un basculement des spins de $\pi$ rad, peuvent être remplacées par des impulsions induisant un basculement d'un angle $\varphi$ non nul et pouvant être inférieur ou égal à $\pi$ rad (impulsions « de basculement »). Le case $\varphi=\pi$ rad (inversion) est préféré car il maximise l'intensité du signal émis par les spins.

Les spins de l'échantillon, excités par une impulsion d'inversion ou de basculement, retournant à l'équilibre en émettant de manière spontanée, et donc incohérente, des photons à la fréquence de Larmor, formant ce qu'on appelle un « bruit de spin ». L'émission spontanée est fortement accélérée par effet Purcell, par conséquent la quasi-totalité de ces photons sont émis dans un mode du résonateur électromagnétiques et couplés à la ligne de transmission LT qui guide leur propagation jusqu'au dispositif de comptage de photons CP. Sur la [Fig. 2], la référence RS' désigne le signal de réponse se propageant le long de la ligne de transmission LT. On peut remarquer que, contrairement au signal RS d'écho de spin de la [Fig. 1], il s'agit justement d'un bruit.

Alors que, comme discuté plus haut en référence à (McCoy 1989), la détection du bruit de spin par des techniques électroniques conventionnelles (démodulation homodyne ou hétérodyne) est peu sensible, les présents inventeurs ont découvert que, de manière inattendue, sa détection par comptage de photons permet d'atteindre une sensibilité plus élevée que l'état de l'art (détection homodyne d'un signal d'écho de spin).

Cela peut être démontré de la manière suivante.

Si N est le nombre de spins dans l'échantillon et p (compris entre 0 et 1, en pratique proche de 1) est la polarisation, le nombre de spins excités est égal $pN$. Ces spins relaxent avec une constante de temps $T_1=(\Gamma_1)^{-1}$. On peut considérer que tous les spins seront relaxé au bout d'une fenêtre d'acquisition suffisamment longue par rapport à $T_1$ - par exemple supérieure ou égale à $5T_1$ voire $10T_1$. La probabilité qu'un spin relaxe en émettant un photon dans un mode du résonateur électromagnétique est égale à $p_1= \Gamma_p/\Gamma_1$. On considère que le compteur de photons a une bande passante égale à $\Gamma_2^*$ qui lui permet, en principe, de collecter tous les photons émis par les spins, et un efficacité quantique $\eta$. Le nombre de photons détectés par le compteur vaut donc $\eta pN\Gamma_P/\Gamma_1$.

Le nombre de photons de bruit (c'est-à-dire ne provenant pas des spins) est donné par $\langle n\rangle\,\Gamma_2^*/\Gamma_1 + \alpha\Gamma_1^{-1}$ où, comme expliqué plus haut, $\langle n\rangle = 1/(e^{\hbar\omega 0/k_B T} - 1)$ est le nombre moyen de photons par mode à la température T et $\alpha$ est le taux de comptes d'obscurité, c'est-à-dire de comptages en l'absence de photons.

Le niveau de bruit correspond l'écart-type du nombre de photons de bruit détecté qui, en supposant que les photons d'obscurité ont une statistique poissonnienne, en est la racine carrée.

Une autre source de bruit vient du fait que le nombre de photons détectés venant des spins lui-même varie, car le nombre de photons émis par les spins est une variable aléatoire avec comme écart-type $\sqrt{p_1(1-p_1)N}$.

L'efficace de détection étant finie, en outre, le nombre de photons détectés est aussi une variable aléatoire, d'écart-type $\sqrt{\eta(1-\eta)N}$.

Au total, l'écart-type du bruit de détection vaut donc

$$\sqrt{\langle n\rangle\,\Gamma_2^{\,*}/\Gamma_1 + \alpha\Gamma_1^{-1} + [p_1(1-p_1) + \eta(1-\eta)]N}.$$

Le rapport signal-sur-bruit de cette méthode de détection incohérente par comptage de photons vaut donc :

$$\mathrm{SN}_{i,CP} = \eta pNp_1 \Big/ \sqrt{\langle n\rangle\,\Gamma_2^{\,*}/\Gamma_1 + \alpha\Gamma_1^{-1} + [p_1(1-p_1) + \eta(1-\eta)]N}$$

où l'indice « i » signifie « incohérent » (donc, bruit de spin) et « CP » désigne la détection par comptage de photons. C'est ici que réside la différence fondamentale avec la méthode conventionnelle de détection homodyne. Alors que le rapport signal-sur-bruit en détection homodyne est intrinsèquement limité à cause des fluctuations du vide qui font que n>_1, avec un comptage de photons il existe un régime de paramètres dans lequel le rapport signal-sur-bruit peut être arbitrairement élevé.

En effet, dans la limite ultime où p=1 (polarisation maximale des spins), $p_1$=1 (les spins relaxent de façon dominante par effet Purcell) et $\langle n\rangle \approx 0$, cette dernière condition correspondant à $T \ll \dfrac{\hbar\omega_0}{k_B}$, on obtient :

$$\mathrm{SN}_{i,CP} = \eta N \Big/ \sqrt{\alpha\Gamma_P^{-1} + \eta(1-\eta)]N},$$

alors que, pour mémoire :

$$SN_{e,h} = 2N\sqrt{\Gamma_P/2\Gamma_2^*}$$

en détection homodyne. Or il n'y a pas de limite théorique à la valeur que peuvent prendre l'efficacité du détecteur ni le taux de compte d'obscurité, c'est-à-dire que $\eta$ peut être aussi proche de 1 que souhaité, et $\alpha(\Gamma_P)^{-1}$ être aussi faible que nécessaire.

$SN_{i,CP}$ peut donc être arbitrairement élevé, et ce même si N=1 et $\Gamma_P/2\Gamma_2^*$ <<1, pour peu que l'efficacité du détecteur soit bonne, et que le taux de comptes d'obscurité soit suffisamment faible.

Il est intéressant de calculer également, à titre de comparaison, le rapport signal-sur-bruit atteignable par détection homodyne du bruit de spin et par comptage de photons sur un signal d'écho de spin.

Dans le cas d'une détection homodyne du bruit de spin, on remarque que la puissance totale émise par les spins est donnée par le nombre de photons émis dans la fenêtre de détection, qui est égale à $pN\Gamma_P/\Gamma_1$ dans une bande passante donnée par $\Gamma_2^*$. La puissance de bruit correspondante est donnée par $n\Gamma_2^*/\Gamma_1$. L'écart-type est $\sqrt{n\Gamma_2^*/\Gamma_1}$ .

Le rapport signal-sur-bruit de cette méthode de détection incohérente homodyne vaut donc :

$$SN_{i,h} = pN\Gamma_P/\sqrt{n\Gamma_1\Gamma_2^*}.$$

On constate que le rapport

$$SN_{e,h}/SN_{i,h} = 2\sqrt{\Gamma_1/\Gamma_P}$$

qui est toujours supérieur à 2, et même très largement supérieur dans les situations où $\Gamma_1 >> \Gamma_P$. A plus forte raison, cette méthode est moins adaptée à la détection de faibles nombres de spins que celle de l'invention.

Dans le cas du comptage des photons d'un signal d'écho de spin, le nombre de photons détectés est donné par $\eta p^2 N^2 (\Gamma_P/2\Gamma_2^*)$, ce qui correspond au carré de l'amplitude du signal multiplié par l'efficacité du détecteur $\eta$.

La durée de l'écho est $(\Gamma_2^*)^{-1}$, par conséquent le nombre de comptes d'obscurité est $\alpha(\Gamma_2^*)^{-1}$. Le niveau de bruit correspond à l'écart-type, c'est-à-dire la racine carrée de ce nombre de comptages. En outre il faut prendre en compte le bruit de grenaille dû à l'écho lui-même, qui est un état cohérent du champ et donc à un écart-type donné par

$$pN\sqrt{(1 + \langle n \rangle)\eta(\Gamma_P/2\Gamma_2^*)}.$$

Le rapport signal sur bruit de la détection d'un signal d'écho de spin par comptage de photons vaut donc

$$SN_{e,CP} = \eta p^2 N^2 (\Gamma_P/2\Gamma_2^*)/\sqrt{\alpha(\Gamma_2^*)^{-1} + \eta p^2 N^2 (1 + \langle n \rangle)(\Gamma_P/2\Gamma_2^*)}.$$

Dans la limite "ultime" où p=1, $\Gamma_1 \approx \Gamma_P$ et $\langle n \rangle \approx 0$, on obtient :

$$SN_{e,CP} = \frac{\eta N^2 \left(\frac{\Gamma_P}{2\Gamma_2^*}\right)}{\sqrt{\alpha(\Gamma_2^*)^{-1} + \eta N^2 \left(\frac{\Gamma_P}{2\Gamma_2^*}\right)}} < SN_{e,h} = 2N\sqrt{\Gamma_P/2\Gamma_2^*}$$

Donc il n'y a pas en principe d'avantage en termes de rapport signal sur bruit à détecter un écho par comptage de photons plutôt qu'en détection homodyne cohérente.

Le rapport $SN_{i,CP}/SN_{e,CP}$ vaut $SN_{i,CPM}/SN_{e,CPM} = (1/N)\sqrt{\Gamma_2^*/\Gamma_P}$ .

On voit donc que la méthode de l'invention est avantageuse par rapport à la détection par comptage d'un signal d'écho lorsque le nombre de spins de l'échantillon est inférieure à

$$N_c = \sqrt{\Gamma_2^*/\Gamma_P}$$

Si N>N$_c$, la méthode de détection par écho de spin et comptage de photons peut donc être plus sensible que la méthode selon l'invention. Mais dans ce cas, il sera généralement préférable d'avoir recours à une détection homodyne classique.

En conclusion, on constate qu'aucune de ces techniques ne permet d'atteindre un rapport signal sur bruit aussi élevé que celui procuré par l'invention dans le cas d'échantillons

Il ressort de ce qui précède que le procédé de l'invention est particulièrement avantageux lorsque le nombre N de spins de l'échantillon est de l'ordre de ou inférieur à $\sqrt{2\Gamma_2^*/\Gamma_P}$ et lorsque $\Gamma_2^*/\Gamma_P \gg 1$, et pourvu que $T_0 \leq \dfrac{\hbar\omega_0}{k_B}$.

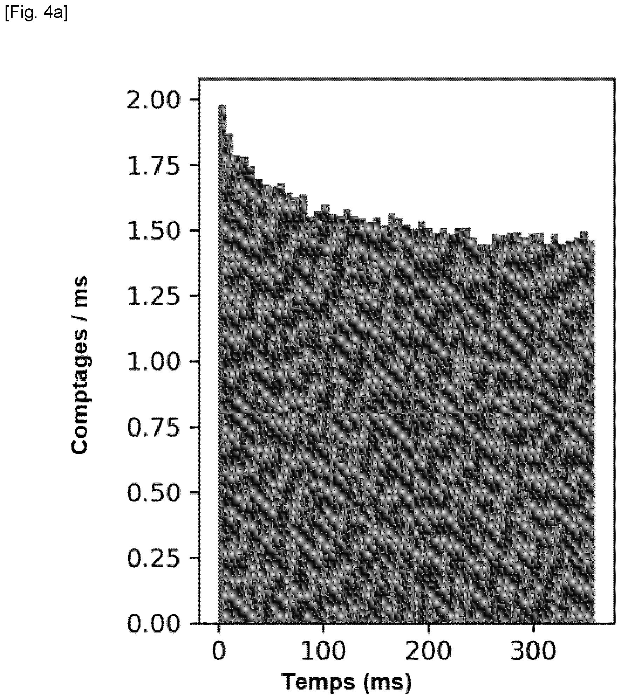

Le résultat technique de l'invention a été validé expérimentalement en détectant le signal d'émission micro-onde venant d'un ensemble de $N \simeq 200$ donneurs (atomes de bismuth) dans le silicium couplé à un résonateur à fréquence $\omega_0$ par un dispositif de comptage de photons hyperfréquences semblable à celui décrit dans la référence (Lescanne 2019) accordé à la fréquence $\omega_0$. Dans cette expérience, $\Gamma_2^* \simeq 10^5 s^{-1}$, $\Gamma_P \simeq 10s^{-1}$, et $\Gamma_1 = \Gamma_P$. Le signal des spins a été détecté selon les deux modalités envisagées dans le brevet. La figure 4a illustre les résultats d'une expérience de comptage des photons du bruit de spin, avec un compteur tel que $\eta \simeq 0,2$ et $\alpha = 1,5ms^{-1}$. On voit que le nombre de photons détectés par unité de temps juste après une impulsion $\pi$ appliquée aux spins décroit exponentiellement avec une constante de temps $\Gamma_P^{-1}=100\text{ms}$, avant de rejoindre une valeur constante correspondant au taux de comptes d'obscurité. Il s'agit de l'émission spontanée des spins par effet Purcell. Le nombre total de comptes détectés lors de chaque séquence, obtenu à partir du graphique de la figure 4a en soustrayant la ligne de base correspondant au comptes d'obscurité (environ 1,5 comptes/ms) et en intégrant le nombre de comptes restants, vaut environ 50, ce qui est proche de la valeur attendue $\eta N$.

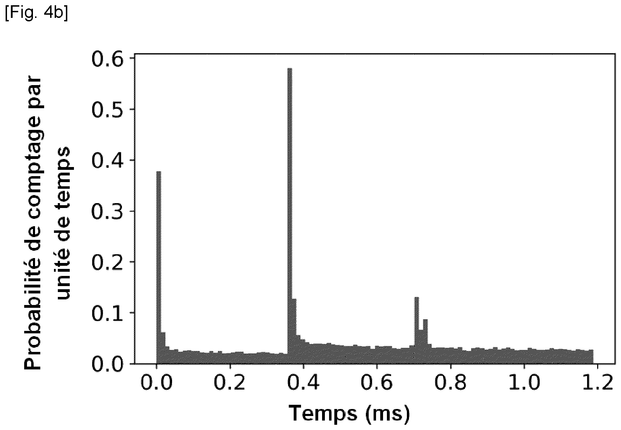

La détection de spins par la méthode d'écho détectée par comptage de photons est démontrée à la figure 4b, qui montre la probabilité de comptage d'un photon par unité de temps, obtenue en moyennant plusieurs séquences d'acquisition. Les deux impulsions micro-ondes destinées à générer le signal d'écho sont visibles aux instants t=0 et t=0,35ms. L'écho de spin est détecté au temps t=0,7ms, comme attendu. L'amplitude du signal est d'environ 0,3 comptes par séquence d'écho, ce qui est proche de la valeur théorique attendue de 0,4 comptes en moyenne.

L'invention a été décrite en référence à son application à la détection de spins électroniques, et plus particulièrement à la spectroscopie de Résonance Paramagnétique Electronique (RPE), mais elle ne s'y limite pas. En particulier, elle peut être appliquée à la détection de spins nucléaires et plus particulièrement à la spectroscopie par Résonance Magnétique Nucléaire (RMN). Cela est important, car alors que peu d'espèces moléculaires présentent des électrons non-appariés détectables par RPE, de très nombreux noyaux - et notamment le plus commun d'entre eux, le proton - présentent un spin nucléaire et sont donc détectables par RMN.

L'extension de la technique de l'invention à la détection de spins nucléaires ne pose aucune difficulté de principe. Cependant, les rapports gyromagnétiques des noyaux atomiques étant inférieurs d'environ trois ordres de grandeur à celui de l'électron, les fréquences de Larmor utilisées en RMN sont typiquement très inférieures à celles rencontrées en RPE (quelques MHz ou dizaines de MHz, au lieu de plusieurs GHz), et cela malgré l'utilisation de champs magnétiques plus intenses. Cela a deux conséquences :

- Premièrement, il est nécessaire de compter des photons à radiofréquence, moins énergétiques que les photons hyperfréquences émis par les spins électroniques.

- Deuxièmement, la condition $T_0 \leq \dfrac{\hbar\omega_0}{k_B}$ qui doit préférentiellement être satisfaite pour obtenir une sensibilité élevée exige un refroidissement encore plus poussé.

Cela rend l'application de l'invention à la détection de spins nucléaires plus complexe, mais pas de manière fondamentale.

Références bibliographiques

(McCoy 1989) « Nuclear spin noise at room température », M.A. McCoy and R.R. Ernst, Chemical Physics Letters 159, 587 (1989).

(Kubo 2012) « Electron spin résonance detected by a superconducting qbit », Y. Kubo et al. Phys. Rev. B 86, 06514 (2012)

(Bienfait 2016) « Reaching the quantum limit of sensitivity in electron spin résonance » A. Bienfait, J. J. Pla, Y. Kubo, M. Stern, X. Zhou, C. C. Lo, C. D. Weis, T. Schenkel, M.L.W. Thewalt, D. Vion, D. Esteve, B. Julsgaard, K. Moelmer, J.J.L. Morton, P. Bertet, Nature Nanotechnology 11, 253 (2016).

(Probst 2017) « Inductive-detection electron-spin résonance spectroscopy with 65 $\text{spins}/\sqrt{\text{Hz}}$ sensitivity » S. Probst, A. Bienfait, P. Campagne-Ibarcq, J.J. Pla, B. Albanese, J.F. Da Silva Barbosa, T. Schenkel, D. Vion, D. Esteve, K. Moelmer, J.J.L. Morton, R. Heeres, P. Bertet, Appl. Phys. Lett. 111, 202604 (2017).

(Walsh 2017) « Graphene-Based Josephson-Junction Single-Photon Detector » Walsh, Evan D., et al. Physical Review Applied, vol. 8, no. 2, Aug. 2017.

(Lescanne 2019) « Detecting itinérant microwave photons with engineered non-linear dissipation » R. Lescanne, S. Deléglise, E. Albertinale, U. Réglade, T. Capelle, E. Ivanov, T. Jacqmin, Z. Leghtas, E. Flurin, arxiv: 1902:05102.

(Ranjan 2020) « Pulsed electron spin résonance spectroscopy in the Purcell régime» V. Ranjan, S. Probst, B. Albanes, A. Doll, O. Jacquit, E. Flurin, R. Heeres, D. Vion, D. Esteve, J.J.M. Morton, P. Bertet, J. Mag. Res. 310 (2020).

**Revendications**

1. Procédé de détection de spin comprenant les étapes suivantes :

   a) placer un échantillon (E) contenant des spins (SE) dans un champ magnétique stationnaire ($B_0$) ;
   b) coupler magnétiquement l'échantillon à un résonateur électromagnétique (REM) présentant une fréquence de résonance $\omega_0/2\pi$ égale à la fréquence de Larmor des spins dans le champ magnétique stationnaire, la constante de couplage et le facteur de qualité du résonateur étant suffisamment élevés pour que le couplage avec le résonateur domine la dynamique de relaxation des spins ;
   c) exciter les spins de l'échantillon au moyen d'une impulsion électromagnétique (IS) radio- ou hyperfréquence à ladite fréquence de Larmor ; et
   d) détecter un signal électromagnétique (RS') émis par les spins de l'échantillon dans un mode du résonateur électromagnétique en réponse à la dite impulsion au moyen d'un dispositif (CP) de comptage de photons à radiofréquence ou hyperfréquence ;

   **caractérisé en ce que** l'impulsion électromagnétique radio- ou hyperfréquence à la fréquence de Larmor est une impulsion de basculement de spin, moyennant quoi le signal détecté est un signal de bruit produit par le retour à l'équilibre des spins.

2. Procédé selon la revendication 1 dans lequel le dispositif de comptage de photons à radiofréquence ou hyperfréquence est espacé du résonateur électromagnétique et connecté à lui par l'intermédiaire d'un guide d'onde ou d'une ligne de transmission (LT).

3. Procédé selon l'une des revendications précédentes dans lequel, au moins pendant les étapes c) et d), l'échantillon est maintenu à une température inférieure, de préférence d'au moins un facteur 10, à $T_0 = \frac{\hbar\omega_0}{k_B}$ où h est la constante de Planck réduite et $k_B$ la constante de Boltzmann.

4. Procédé selon l'une des revendications précédentes dans lequel, lors de l'étape d), la détection du signal électromagnétique est effectuée pendant une fenêtre d'acquisition de durée comprise entre $0{,}5 \cdot \Gamma_1^{-1}$ et $10 \cdot \Gamma_1^{-1}$, et de préférence entre $\Gamma_1^{-1}$ et $5 \cdot \Gamma_1^{-1}$, où $\Gamma_1$ est le taux de relaxation des spins de l'échantillon couplé avec le résonateur électromagnétique.

5. Procédé selon l'une des revendications précédentes dans lequel la constante de couplage g entre les spins de l'échantillon et le résonateur électromagnétique, le facteur de qualité du résonateur électromagnétique à la fréquence de Larmor et le taux de décohérence $\Gamma_2^*$ des spins de l'échantillon sont choisis de telle sorte que $\dfrac{\Gamma_P}{\Gamma_2^*} < 1$ et de préférence $\dfrac{\Gamma_P}{\Gamma_2^*} < 0,1$, où $\Gamma_P = \dfrac{4Qg^2}{\omega_0}$.

6. Procédé selon l'une des revendications précédentes dans lequel l'impulsion de basculement de spin est une impulsion d'inversion de spin.

7. Procédé selon l'une des revendications précédentes dans lequel le dispositif de comptage de photons à radiofréquence ou hyperfréquence est un qubit supraconducteur,

8. Procédé selon la revendication 7 dans lequel le qubit supraconducteur est du type à transmon.

9. Procédé selon l'une des revendications précédentes dans lequel les spins de l'échantillon sont des spins électroniques.

**Patentansprüche**

1. Spinerkennungsverfahren, das die folgenden Schritte umfasst:

   a) Platzieren einer Spins (SE) enthaltenden Probe (E) in einem stationären Magnetfeld ($B_0$);
   b) magnetisches Koppeln der Probe an einen elektromagnetischen Resonator (REM) mit einer Resonanzfrequenz $\omega_0/2\pi$, die gleich der Larmor-Frequenz der Spins im stationären Magnetfeld ist, wobei die Kopplungskonstante und der Qualitätsfaktor des Resonators ausreichend hoch sind, damit die Kopplung mit dem Resonator die Relaxationsdynamik der Spins dominiert;
   c) Anregen der Spins der Probe mittels eines elektromagnetischen Hochfrequenz- oder Mikrowellenimpulses (IS) mit der Larmor-Frequenz; und
   d) Erkennen eines elektromagnetischen Signals (RS'), das von den Spins der Probe in einem Modus des elektromagnetischen Resonators als Reaktion auf den Impuls mittels einer Hochfrequenz- oder Mikrowellen-Photonenzählvorrichtung (CP) emittiert wird;

   **dadurch gekennzeichnet, dass** der elektromagnetische Hochfrequenz- oder Mikrowellenimpuls mit der Larmor-Frequenz ein Spin-Umklappimpuls ist, wodurch das erkannte Signal ein durch die Rückkehr der Spins auf Äquilibrium erzeugtes Rauschsignal ist.

2. Verfahren nach Anspruch 1, wobei die Hochfrequenz- oder Mikrowellen-Photonenzählvorrichtung von dem elektromagnetischen Resonator beabstandet und mit diesem über einen Wellenleiter oder eine Übertragungsleitung (LT) verbunden ist.

3. Verfahren nach einem der vorherigen Ansprüche, wobei die Probe mindestens während der Schritte c) und d) auf einer Temperatur gehalten wird, die vorzugsweise um mindestens einen Faktor 10 niedriger als $T_0 = \dfrac{\hbar\omega_0}{k_B}$ ist, worin h die reduzierte Planck-Konstante und $k_B$ die Boltzmann Konstante ist.

4. Verfahren nach einem der vorhergehenden Ansprüche, wobei in Schritt d) die Erkennung des elektromagnetischen Signals während eines Erfassungsfensters mit einer Dauer zwischen $0,5 \cdot \Gamma_1^{-1}$ und $10 \cdot \Gamma_1^{-1}$ vorzugsweise zwischen $\Gamma_1^{-1}$ und $5 \cdot \Gamma_1^{-1}$ erfolgt, worin $\Gamma_1$ die Relaxationsrate der Spins der mit dem elektromagnetischen Resonator gekoppelten Probe ist.

5. Verfahren nach einem der vorhergehenden Ansprüche, wobei die Kopplungskonstante g zwischen den Spins der Probe und dem elektromagnetischen Resonator, der Gütefaktor des elektromagnetischen Resonators bei der Larmor-Frequenz und die Dekohärenzrate $\Gamma_2^*$ der Spins der Probe so gewählt sind, dass $\frac{\Gamma_P}{\Gamma_2^*} < 1$ und vorzugsweise $\frac{\Gamma_P}{\Gamma_2^*} < 0,1$, worin $\Gamma_P = \frac{4Qg^2}{\omega_0}$.

6. Verfahren nach einem der vorhergehenden Ansprüche, wobei der Spin-Umklappimpuls ein Spin-Umkehrimpuls ist.

7. Verfahren nach einem der vorhergehenden Ansprüche, wobei die Hochfrequenz- oder Mikrowellen-Photonenzählvorrichtung ein supraleitendes Qubit ist.

8. Verfahren nach Anspruch 7, wobei das supraleitende Qubit vom Transmon-Typ ist.

9. Verfahren nach einem der vorhergehenden Ansprüche, wobei die Spins der Probe Elektronenspins sind.

## Claims

1. A spin-detection method comprising the following steps:

   a) placing a sample (E) containing spins (SE) in a stationary magnetic field (B$_0$);
   b) magnetically coupling the sample to an electromagnetic resonator (REM) having a resonant frequency $\omega_0/2\pi$ equal to the Larmor frequency of the spins in the stationary magnetic field, the coupling constant and the quality factor of the resonator being sufficiently high for the coupling to the resonator to dominate the dynamics of relaxation of the spins;
   c) exciting the spins of the sample by means of a radio-frequency or microwave electromagnetic pulse (IS) at said Larmor frequency; and
   d) detecting an electromagnetic signal (RS') emitted by the spins of the sample in a mode of the electromagnetic resonator in response to said pulse by means of a device (CP) for counting radio-frequency or microwave photons;

   **characterized in that** the radio-frequency or microwave electromagnetic pulse at the Larmor frequency is a spin-flipping pulse, whereby the detected signal is a noise signal produced by the return of the spins to equilibrium.

2. The method according to claim 1, wherein the device for counting radio-frequency or microwave photons is spaced apart from the electromagnetic resonator and connected thereto via a waveguide or a transmission line (LT).

3. The method according to one of the preceding claims, wherein, at least during steps c) and d), the sample is kept at a temperature lower, preferably by at least a factor 10, than $T_0 = \frac{\hbar\omega_0}{k_B}$ where h is the reduced Planck constant and $k_B$ is Boltzmann's constant.

4. The method according to one of the preceding claims, wherein in step d), the electromagnetic signal is detected during an acquisition window of duration comprised between $0.5 \cdot \Gamma_1^{-1}$ and $10 \cdot \Gamma_1^{-1}$, and preferably between $\Gamma_1^{-1}$ and $5 \cdot \Gamma_1^{-1}$, where $\Gamma_1$ is the relaxation rate of the spins of the sample coupled to the electromagnetic resonator.

5. The method according to in one of the preceding claims, wherein the coupling constant g between the spins of the sample and the electromagnetic resonator, the quality factor of the electromagnetic resonator at the Larmor frequency and the decoherence rate $\Gamma_2^*$ of the spins of the sample are chosen such that $\frac{\Gamma_P}{\Gamma_2^*} < 1$ and preferably $\frac{\Gamma_P}{\Gamma_2^*} < 0.1$

$$\Gamma_P = \frac{4Qg^2}{\omega_0}$$
, where            .

6. The method according to one of the preceding claims, wherein the spin-flipping pulse is a spin-inverting pulse.

7. The method according to one of the preceding claims, wherein the device for counting radio-frequency or microwave photons is a superconducting qubit.

8. The method according to claim 7, wherein the superconducting qubit is of transmon type.

9. The method according to one of the preceding claims, wherein the spins of the sample are electron spins.

EP 4 127 759 B1

[Fig. 1]

[Fig. 2]

[Fig. 3]

[Fig. 4a]

[Fig. 4b]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Littérature non-brevet citée dans la description

- **M.A. MCCOY ; R.R. ERNST.** Nuclear spin noise at room température. *Chemical Physics Letters,* 1989, vol. 159, 587
- **Y. KUBO et al.** *Phys. Rev.,* 2012, vol. 86, 06514
- **A. BIENFAIT ; J. J. PLA ; Y. KUBO ; M. STERN ; X. ZHOU ; C. C. LO ; C. D. WEIS ; T. SCHENKEL ; M.L.W. THEWALT ; D. VION.** Reaching the quantum limit of sensitivity in electron spin résonance. *Nature Nanotechnology,* 2016, vol. 11, 253
- **S. PROBST ; A. BIENFAIT ; P. CAMPAGNE-IBARCQ ; J.J. PLA ; B. ALBANESE ; J.F. DA SILVA BARBOSA ; T. SCHENKEL ; D. VION ; D. ESTEVE ; K. MOELMER.** *Appl. Phys. Lett.,* 2017, vol. 111, 202604
- **WALSH, EVAN D. et al.** Graphene-Based Josephson-Junction Single-Photon Detector. *Physical Review Applied,* Août 2017, vol. 8 (2
- **R. LESCANNE ; S. DELÉGLISE ; E. ALBERTINALE ; U. RÉGLADE ; T. CAPELLE ; E. IVANOV ; T. JACQMIN ; Z. LEGHTAS ; E. FLURIN.** Detecting itinérant microwave photons with engineered non-linear dissipation. *arxiv: 1902:05102.*
- **V. RANJAN ; S. PROBST ; B. ALBANES ; A. DOLL ; O. JACQUIT ; E. FLURIN ; R. HEERES ; D. VION, D. ESTEVE ; J.J.M. MORTON ; P. BERTET.** Pulsed electron spin résonance spectroscopy in the Purcell régime. *J. Mag. Res.,* 2020, vol. 310